# EUROPÄISCHE PATENTSCHRIFT

(11) **EP 3 513 438 B1**
(45) Veröffentlichungstag und Bekanntmachung des Hinweises auf die Patenterteilung: **16.12.2020**
(21) Anmeldenummer: 17768089.9
(22) Anmeldetag: 13.09.2017
(51) Int. Cl.: H01L 31/02

(54) **SOLARMODUL UND ENERGIEERZEUGUNGSANLAGE**
SOLAR MODULE AND ENERGY-GENERATING SYSTEM
MODULE SOLAIRE ET CENTRALE DE PRODUCTION D'ÉNERGIE

(30) Priorität: 13.09.2016 DE 102016117229
(43) Veröffentlichungstag der Anmeldung: 24.07.2019
(73) Patentinhaber: SMA Solar Technology AG, 34266 Niestetal (DE)
(72) Erfinder: HOPF, Markus, 34314 Espenau (DE); MUELLER, Burkard, 34123 Kassel (DE); PRIOR, Oliver, 34431 Marsberg (DE)
(86) Internationale Anmeldenummer: PCT/EP2017/072989
(87) Internationale Veröffentlichungsnummer: WO 2018/050681

(56) Entgegenhaltungen:
- WO-A2-2013/121003
- DE-A1-102011 079 074
- DE-A1-102013 101 314

## Beschreibung

Die Erfindung betrifft ein Solarmodul mit eigenständig freischaltenden Teilmodulen, sowie eine Energieerzeugungsanlage unter Verwendung solcher Solarmodule.

In photovoltaischen Energieerzeugungsanlagen werden einzelnen Solarmodule miteinander in Reihe beziehungsweise parallel verschaltet, um dann Spannungen und Ströme zu liefern, die weitaus höhere Werte annehmen als die eines einzelnen Solarmoduls. In einem Fehler-oder Gefahrenfall ist es wünschenswert, diese Verschaltung auf ein Freischaltsignal hin derart aufzutrennen, dass sichergestellt ist, dass an keinem Punkt der Energieerzeugungsanlage gefährliche Spannungen auftreten.

Es ist daher in der Schrift WO2013/121003 A2 offenbart, ein Solarmodul mit einer Reihe von Schaltern verschiedenen Typs zu versehen, um je nach Erfordernis das gesamte Modul oder Teilmodule kurzzuschließen und damit spannungsfrei zu schalten. Weiterhin kann auch im Kurzschlussfall über einen zusätzlichen Schalter eine Betriebsspannung für eine Steuerung erzeugt werden.

Es ist weiterhin aus der Schrift DE 10 2006 060 815 A1 bekannt, jedes Solarmodul mit einem eigenen Trennschalter beziehungsweise Kurzschließer zu versehen, die auf ein Freischaltsignal hin, das von einem Wechselrichter ausgesandt wird, das zugeordnete Solarmodul spannungsfrei zu schalten. Hierbei muss der Trennschalter beziehungsweise der Kurzschließer mindestens auf die gesamte Leerlaufspannung des Solarmoduls, typischerweise 80 Volt, ausgelegt sein. Eine kostengünstigere und betriebssicherere Variante wäre es, einzelne Teilmodule, aus denen die Solarmodule zusammengesetzt sind, jeweils spannungsfrei zu schalten, so dass wesentlich günstigere Schalter einsetzbar sind, die nur noch auf die Leerlaufspannung der Teilmodule, typischerweise 30 Volt, ausgelegt sein müssen.

So können beispielsweise die in WO 2006/125664 A1 für eine Verwendung im Abschattungsfall einzelner Solarmodule offenbarten aktiven Bypassdioden verwendet werden, die einen geeigneten Halbleiterschalter aufweisen, mit denen auch Teilmodule überbrückt werden können. Dies führt allerdings zu dem Nachteil, dass das Solarmodul bei aktivierter Überbrückung keinen Beitrag zu einer Stromversorgung einer Sicherheitsschaltung zur Ansteuerung der Halbleiterschalter leisten kann, so dass auf eine andere Energiequelle zurückgegriffen werden muss, was zusätzliche Kosten verursacht. Es ist daher Aufgabe der vorliegenden Erfindung, ein Solarmodul beziehungsweise eine Energieerzeugungsanlage aufzuzeigen, die Sicherheitskriterien im Fall einer erforderlichen Freischaltung erfüllen und kostengünstig herstellbar sind.

Diese Aufgabe wird durch das Solarmodul des unabhängigen Anspruchs 1, sowie einer Energieerzeugungsanlage des nebengeordneten Anspruchs 10 gelöst. Die auf diese Ansprüche jeweils zurückbezogenen abhängigen Ansprüche zeigen bevorzugte Ausführungsformen der Erfindung auf.

Ein Aspekt der Erfindung betrifft ein Solarmodul mit einer zwischen Anschlüssen angeordneten Reihenschaltung von Bypassdioden mit Bypassanschlüssen jeweils an beiden Enden und allen Verbindungspunkten der Bypassdiodenreihenschaltung. Weiterhin umfasst das Solarmodul eine Reihenschaltung von Solarteilmodulen mit jeweils an beiden Enden und allen Verbindungspunkten der Solarmodulreihenschaltung, wobei jede Bypassdiode genau einem Solarteilmodul zugeordnet ist. Eine Mehrzahl von Halbleiterschaltern ist zur Spannungsfreischaltung der Solarmodulanschlüsse bei Empfang eines Freischaltsignals durch eine Sicherungseinheit vorgesehen, wobei jeder der Mehrzahl von Halbleiterschaltern dazu eingerichtet ist, ein ihnen zugeordnetes Solarteilmodul spannungslos oder stromlos zu schalten. Es werden also mindestens so viele Halbleiterschalter verwendet, wie Solarteilmodule vorhanden sind. Mindestens ein Bypassanschluss ist direkt mit dem zugeordneten Teilmodulanschluss und mindestens ein Bypassanschluss über einen der Halbleiterschalter mit dem zugeordneten Teilmodulanschluss verbunden. Durch diese Art der Verbindung ist sichergestellt, dass immer mindestens ein Solarteilmodul nicht kurzgeschlossen ist, auch wenn das Solarmodul spannungslos oder stromlos geschaltet ist. Vorteilhaft ist die Sicherungseinheit zur Energieversorgung aus der an dem nicht kurzgeschlossenen Teilmodul abfallende Spannung eingerichtet, so dass diese keine eigenständige Energieversorgung benötigt. Selbst im Fall einer Verschattung des Solarmoduls, in dem ein Strom über die Solarmodulanschlüsse über die Reihenschaltung der Bypassdioden gelenkt wird, kann durch das Öffnen des den Bypassanschluss mit dem Teilmodulanschluss verbindenden Halbleiterschalters ein zur Versorgung der Sicherungseinheit ausreichender Spannungsabfall an der Reihenschaltung der Solarteilmodule erreicht werden.

Die Halbleiterschalter, die Sicherungseinheit und die Halbleiterdioden können vorzugsweise als Modulelektronik auf der Rückseite des Solarmoduls in einem Gehäuse, beispielsweise einer Anschlussdose, untergebracht und mit den dort aus dem Solarmodul ragenden Teilmodulanschlüssen der Solarmodulreihenschaltung verbunden sein. Zumeist weisen marktübliche Solarmodule drei Solarteilmodule auf, die Erfindung kann aber auch bei einer anderen Anzahl von Solarteilmodulen praktiziert werden.

Die Anzahl der Halbleiterschalter kann der Anzahl der Solarteilmodule entsprechen, so dass jedes Teilmodul durch genau einen der Halbleiterschalter stromlos oder spannungslos geschaltet werden kann. Es ist aber auch möglich, dass mehrere Halbleiterschalter einem Solarteilmodul zugeordnet sind und dieses durch alternative Ansteuerung oder in ergänzender Ansteuerung stromlos oder spannungslos zu schalten.

Dadurch, dass jeweils ein Halbleiterschalter ein zugeordnetes Solarteilmodul spannungslos oder stromlos schaltet, kann die maximale Spannungsbelastung aller oder mindestens einiger der Halbleiterschalter auf die Leerlaufspannung eines Solarteilmoduls begrenzt werden. Hierdurch wird der Einsatz wesentlich kostengünstiger Halbleiterschalter ermöglicht als im Fall, dass das gesamte Solarmodul durch einen Schalter spannungsfrei geschaltet werden muss. Hierdurch können auch als Schalter mit geringerem Innenwiderstand gewählt werden, so dass auch im normalen Betriebsfall elektrische Verluste verringert und damit insbesondere auch die thermische Belastung der verwendeten Komponenten verbessert werden können.

Vorteilhafterweise ist in dem Solarmodul mindestens eine Bypassdiode durch einen der Halbleiterschalter überbrückt, der von der Sicherungseinheit bei Empfang des Freischaltsignals geschlossen wird, um das zugeordnete Solarteilmodul kurzzuschließen und so spannungsfrei zu machen. Bevorzugt befindet sich das kurzzuschließende Solarteilmodul in einer inneren Position der Reihenschaltung der Solarmodule, also nicht an einem der Enden der Reihenschaltung. Es ist denkbar, den Halbleiterschalter auch dann zu schließen, wenn die überbrückte Bypassdiode einen Strom führt, beispielsweise verursacht durch eine Abschattung des zugeordneten Solarteilmoduls. Hier wirkt diese Halbleiterschalter dann wie eine aktive Freilaufdiode und reduziert den Spannungsabfall der Bypassdiode, was wiederum zu einer thermischen Entlastung der Bypassdiode und der gesamten Modulelektronik führt.

In einer bevorzugten Ausführung der Erfindung ist der den mindestens einen Bypassanschluss mit dem zugeordneten Teilmodulanschluss verbindende Halbleiterschalter direkt mit einem der Solarmodulanschlüsse verbunden. Hierdurch kann ein Solarteilmodul an einem Ende der Solarmodulreihenschaltung auch dann eine Versorgungsspannung für die Sicherungseinheit bereitstellen, wenn das Solarmodul spannungsfrei geschaltet ist. Ein Teil oder alle der übrigen Solarteilmodule können dann durch die Bypassdiode überbrückende Halbleiterschalter kurzgeschlossen werden, um das Solarmodul spannungsfrei zu schalten. In einer vorteilhaften Ausführung ist jeder Solarmodulanschluss jeweils mit einem einen Bypassanschluss mit dem zugeordneten Solarteilmodulanschluss verbindenden Halbleiterschalter direkt verbunden, so dass beide äußeren, also die den Solarmodulanschlüssen nächstliegenden Solarteilmodule dann eine Versorgungsspannung für die Sicherungseinheit bereitstellen können. Das oder die zwischen diesen Solarteilmodulen angeordneten Solarteilmodule werden dann bevorzugt durch die zugeordneten Bypassanschlüsse überbrückende Halbleiterschalter kurzschließbar ausgeführt.

Ist ein Solarteilmodul durch einen die zugeordneten Bypassanschlüsse überbrückenden Halbleiterschalter kurzschließbar ausgeführt, so ist es bevorzugt, diese Bypassanschlüsse direkt mit den zugeordneten Teilmodulanschlüssen zu verbinden, also keine Halbleiterschalter in der Verbindung vorzusehen. Die benachbarten Solarteilmodule können dann ebenfalls als kurzschließbare Solarteilmodule ausgeführt sein, oder ein Halbleiterschalter ist zwischen dem entsprechenden Teilmodulanschluss und dem Bypassanschluss auf der dem kurzschließbar ausgeführten Solarteilmodul abgewandten Seite des benachbarten Solarteilmodul angeordnet. Auf diese Weise brauchen die entsprechenden Halbleiterschalter hinsichtlich ihrer Spannungsfestigkeit nur auf die Leerlaufspannung eines Solarteilmoduls ausgelegt zu werden.

Sofern es die Betriebssicherheit erfordert, kann dem die Bypassdiode überbrückenden ersten Halbleiterschalter ein weiterer, redundanter Halbleiterschalter parallelgeschaltet sein. Beide können von der Sicherungseinheit gemeinsam betrieben werden, oder der redundante Halbleiterschalter wird nur betrieben, wenn der ersten Halbleiterschalter nicht ordnungsgemäß funktioniert. Es ist von Vorteil, jeweils einen normal offenen und einen normalen geschlossenen Schalter für den ersten und den weiteren, redundante Halbleiterschalter zu verwenden. Auf diese Weise ist es möglich, das Solarteilmodul auch dann kurzzuschließen, wenn die Sicherungseinheit nicht ausreichend mit Energie versorgt werden kann, zum Beispiel während der Dämmerungsphase. Gleichzeitig ist es möglich, den niedrigeren Innenwiderstand eines normal offenen Schalters gegenüber einem normal geschlossenen Schalter verlustmindernd zu nutzen. Es ist aber auch denkbar, die Verwendung eines redundante Halbleiterschalters zu vermeiden, indem die Sicherungseinheit so ausgeführt wird, dass sie bereits bei geringer von den Solarteilmodulen erzeugter Spannung betriebsbereit ist und den oder die parallel zu den Bypassdioden angeordneten Halbleiterschalter schließt, damit die von diesen Halbleiterschaltern zugeordneten Solarteilmodulen erzeugte Spannung nicht an dem Solarmodulanschlüssen anliegt.

Die Halbleiterschalter können als IGBT oder als Feldeffekttransistoren, insbesondere als MOSFET, ausgeführt sein und eine intrinsische oder eine separate Freilaufdiode aufweisen. Sie können als normal offene oder normal geschlossene Transistoren ausgeführt sein, wobei die zwischen Bypassanschluss und Teilmodulanschluss angeordneten Halbleiterschalter vorzugsweise normal geschlossene und die parallel zu den Bypassdioden angeordneten Halbleiterschalter vorzugsweise normal offene Schalter sein können.

Das erfindungsgemäße Solarmodul kann bevorzugt innerhalb einer Energieerzeugungsanlage verwendet werden. Insbesondere können alle Solarmodule der Energieerzeugungsanlage erfindungsgemäß ausgeführt sein. Das Freischaltsignal kann zentral erzeugt werden, wodurch alle Solarmodule im Bedarfsfall schnell und zuverlässig spannungsfrei geschaltet werden können.

Das Freischaltsignal kann auch als Totmanns-Signal ausgeführt sein, so dass sich die Solarmodule spannungsfrei schalten, nachdem sie eine vorgegebene Zeit kein Totmanns-Signal empfangen haben.

Neben dem Freischaltsignal kann die Sicherungseinheit des erfindungsgemäßen Solarmoduls auch zum Empfang eines Signals zur Spannungsreduzierung eingerichtet sein. Beim Empfang dieses Signals kann die Sicherungseinheit gezielt einen Teil der Teilmodule durch Ansteuerung der ihnen zugeordneten Halbleiterschalter von der Energieerzeugung ausnehmen, wodurch sich die an den Solarmodulanschlüssen anliegende Spannung reduziert. Es ist ebenfalls denkbar, dass die Sicherungseinheit die Herausnahme einzelner Solarteilmodule aus der Energieerzeugung eigenständig durchführt, beispielsweise durch ein Vergleich der an den Solarteilmodulen abfallenden Spannung mit vorgegebenen Schwellwerten, so dass bei Überschreiten der Schwellwerte die spannungsreduzierende Ansteuerung der Halbleiterschalter durch die Sicherungseinheit vorgenommen wird.

Innerhalb einer Energieerzeugungsanlage befinden sich regelmäßig mehrere Reihenschaltungen von Solarmodulen, die zueinander parallelgeschaltet sind. In einer solchen Konfiguration ist es auch wichtig, den Fall eines Rückstroms zu betrachten, also einer Stromrichtung entgegen der normalen Betriebsstromrichtung, der entsteht, wenn die Spannung eines Strings die Leerlaufspannung eines anderen Strings überschreitet. Ein solcher Fall kann mit erfindungsgemäßen Solarmodulen auch dadurch auftreten, dass die Solarmodule bei Empfang des Freischaltsignals nicht gleichzeitig in einen spannungsfreien Zustand übergehen. Hierdurch kann es zu erheblichen Rückströmen kommen, die kontrolliert werden müssen. Daher ist es in einem erfindungsgemäßen Solarmodul von Vorteil, zunächst die zwischen den Bypassanschlüssen und den Teil Modulanschlüssen angeordneten Halbleiterschalter zu öffnen. Die parallel zu den Bypassdioden angeordneten Halbleiterschalter werden erst dann geöffnet, wenn sichergestellt ist, dass kein Rückstrom durch das Solarmodul fließt. Diese Bedingung ist zum Beispiel erfüllt, wenn die über den oder die parallel zu einer Bypassdiode angeordneten Halbleiterschalter abfallende Spannung gleich dem Spannungsabfall zwischen den Solarmodulanschlüssen ist. Die Prüfung dieser Bedingungen wird vorzugsweise durch die Sicherungseinheit durchgeführt.

Im Rückstromfall ist es weiterhin von Vorteil, die zwischen den Bypassanschlüssen und den Teilmodulanschlüssen angeordneten Halbleiterschalter zu schließen, um die Verluste durch die Bestromung ihrer Freilaufdioden zu verringern.

Im Folgenden werden die Erfindung und einige ihrer Ausführungsvarianten mithilfe von Figuren näher erläutert, wobei
- Fig. 1: eine erste erfindungsgemäße Ausführungsform eines Solarmoduls,
- Fig. 2: eine zweite erfindungsgemäße Ausführungsform eines Solarmoduls,
- Fig. 3: eine dritte erfindungsgemäße Ausführungsform eines Solarmoduls,
- Fig. 4: eine vierte erfindungsgemäße Ausführungsform eines Solarmoduls, sowie
- Fig. 5: eine fünfte erfindungsgemäße Ausführungsform eines Solarmoduls zeigt.

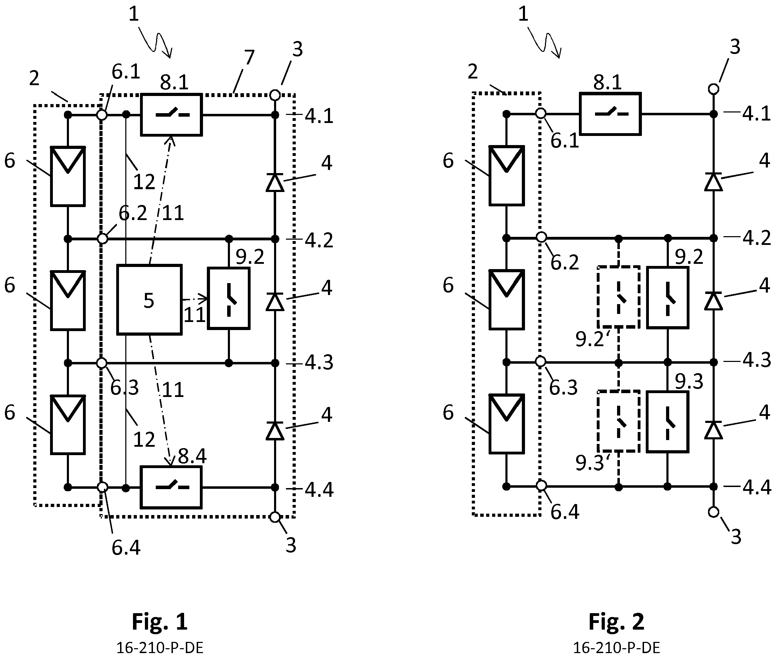

Fig. 1 zeigt ein erfindungsgemäßes Solarmodul 1, zwischen dessen Solarmodulanschlüssen 3 eine Reihenschaltung von Bypassdioden 4 angeordnet ist. Zwischen den Bypassdioden 4 sind Bypassanschlüsse 4.1 bis 4.4 vorgesehen, die direkt beziehungsweise über Halbleiterschalter 8.1 und 8.4 mit korrespondierenden Teilmodulanschlüssen 6.1 bis 6.4 verbunden sind. Die Teilmodulanschlüsse 6.1 bis 6.4 sind elektrische Anschlüsse einer Reihenschaltung 2 von drei Teilmodulen 6, die ihrerseits eine Reihenschaltung einer Mehrzahl von Solarzellen aufweisen können. Die Teilmodulanschlüssen 6.1 bis 6.4 sind an beiden Enden beziehungsweise an den Verbindungspunkten zwischen den Teilmodulen 6 angeordnet. Zusätzlich ist die mittlere Bypassdiode 4 über einen hierzu parallel angeordneten Halbleiterschalter 9.2 überbrückbar.

Die Halbleiterschalter 8.1, 8.4 und 9.2 werden gemeinsam von einer Sicherungseinheit 5 angesteuert. Im Betriebsfall sind die Halbleiterschalter 8.1 und 8.4 geschlossen, während der Halbleiterschalter 9.2 geöffnet ist. In diesem Fall wird die Summenspannung der Teilmodule 6 an den Solarmodulanschlüssen 3 bereitgestellt, sofern die Summenspannung positiv ist. Nur bei negativer Summenspannung, die beispielsweise im Falle einer Verschattung des Solarmoduls 1 auftreten kann, wenn dieses als Teil eines Strings in Reihenschaltung mit weiteren Solarmodulen und parallel zu weiteren Strings angeordnet ist, fließt ein über die Solarmodulanschlüssen eingespeister Stringstrom über die Reihenschaltung der Bypassdioden 4 oder über Teile derselben.

Im Fall einer gefährlichen Situation oder wenn dies aus anderen Gründen wünschenswert erscheint, empfängt die Sicherungseinheit 5 ein Signal, dass das Solarmodul 1 in einen spannungsfreien Zustand geschaltet werden soll. In diesem Fall veranlasst die Sicherungseinheit 5 über entsprechende Schaltsignale 11, dass die Halbleiterschalter 8.1 und 8.4 geöffnet werden und der Halbleiterschalter 9.2 geschlossen wird. Durch das Schließen des Halbleiterschalters 9.2 wird das zugeordnete mittlere Teilmodul 6 der Reihenschaltung 2 kurzgeschlossen, während die äußeren Teilmodule 6 der Reihenschaltung 2 in den Leerlauf, also in einen stromlosen Zustand gebracht werden. Die Solarmodulanschlüssen 3 werden hierdurch spannungsfrei geschaltet.

Selbst wenn über die Solarmodulanschlüssen 3 weiterhin ein Stringstrom getrieben wird, entsteht zwischen den Solarmodulanschlüssen 3 ein maximaler Spannungsabfall in der Höhe des doppelten Wertes der Diodendurchlassspannung der Bypassdioden 4. Im Sinne dieser Erfindung wird ein solcher geringer Spannungsabfall mit als spannungsfreier Zustand bezeichnet.

Über die geöffneten Halbleiterschalter 8.1 und 8.4 fällt im spannungsfreien Zustand des Solarmoduls eine maximale Spannung in Höhe der Leerlaufspannung eines Teilmoduls 6 ab. Hierdurch wird es möglich, für alle verwendeten Halbleiterschalter 8.1, 8.4 und 9.2 Schalter mit einer maximalen Betriebsspannung in der Höhe der Leerlaufspannung eines Teilmoduls einzusetzen. Eine Auslegung der Halbleiterschalter auf die Leerlaufspannung des gesamten Solarmoduls 1 oder gar auf noch höhere Werte, beispielsweise auf die maximale Stringspannung, ist nicht erforderlich, wodurch sich die Kosten für die verwendeten Halbleiterschalter auf einen Bruchteil der Kosten für Halbleiterschalter, die das gesamte Solarmodul 1 kurzschließen oder trennen können, reduziert.

Zur Energieversorgung der Sicherungseinheit 5 ist diese über Versorgungsleitungen 12 mit den Teilmodulanschlüssen 6.1 und 6.4 verbunden. Sowohl im Betriebsfall als auch in spannungsfreien Zustand des Solarmoduls 1 fällt zwischen den Teilmodulanschlüssen 6.1 und 6.4 ausreichend Spannung für eine Energieversorgung der Sicherungseinheit 5, in diesem Fall mindestens der doppelte Wert einer Teilmodulspannung, ab. Eine eigenständige Energieversorgung, zum Beispiel eine Batterie, ist somit nicht erforderlich. Selbstverständlich ist es ebenfalls denkbar, die Versorgungsleitungen 12 zwischen den Teilmodulanschlüssen 6.1 und 6.2 oder zwischen den Teilmodulanschlüssen 6.3 und 6.4 vorzusehen und nur eines der Teilmodule 6 zur Energieversorgung der Sicherungseinheit 5 zu verwenden.

Bevorzugt ist die Modulelektronik 7, hier umfassend die Halbleiterschalter. 8.1, 8.4 und 9.2, sowie die Sicherungseinheit 5 und die Bypassdioden 4 gemeinsam in einer Anschlussdose auf der Rückseite des Solarmoduls 1 untergebracht und dort mit den aus dem Solarmodul 1 herausragenden Teilmodulanschlüssen 6.1 bis 6.4 verbunden.

Eine Variante eines erfindungsgemäßen Solarmoduls 1 ist in Fig. 2 gezeigt. Anstelle des Halbleiterschalters 8.4 aus Fig. 1 ist ein weiterer, parallel zu einer weiteren Bypassdiode 4 angeordneter Halbleiterschalter 9.3 vorgesehen. Der Teilmodulanschluss 6.4 ist direkt mit dem Bypassanschluss 4.4 verbunden. Zur vereinfachten Darstellung ist die Sicherungseinheit 5 in der Fig. 2 nicht gezeigt, soll aber mit umfasst sein. Optional können den beiden parallel zu Bypassdioden 4 angeordneten Halbleiterschaltern 9.2 und 9.3 jeweils redundante weitere Halbleiterschalter 9.2' und 9.3' parallelgeschaltet sein, die von der Sicherungseinheit 5 ebenfalls in gleicher Weise wie die Halbleiterschalter 9.2 und 9.3 angesteuert werden. Die weiteren Halbleiterschalter 9.2' 9.3' dienen dazu, auch bei Ausfall des jeweils parallel geschalteten Halbleiterschalters 9.2 und 9.3 sicherzustellen, dass zwischen den Solarmodulanschlüssen 3 keine Spannung entsteht. Die weiteren Halbleiterschalter 9.2' 9.3' können gemeinsam mit den parallel geschalteten Halbleiterschaltern 9.2 und 9.3 angesteuert werden oder anstelle dieser, wenn ein Ausfall der Halbleiterschalter 9.2 und/oder 9.3 festgestellt wird.

Auch bei dieser Anordnung der Halbleiterschalter ist sichergestellt, dass über keinen Halbleiterschalter eine höhere Spannung als die Leerlaufspannung eines Teilmoduls 6 abfällt. Gleichzeitig kann auch im spannungsfreien Zustand des Solarmoduls eine Versorgungsspannung für die Sicherungseinheit 5 aus der Reihenschaltung 2 der Teilmodule 6 erzeugt werden, sodass keine zusätzliche Energieversorgung für die Sicherungseinheit 5 vorgesehen werden muss.

Bei allen Ausführungsformen können die den Bypassdioden 4 parallel geschalteten Halbleiterschalter im Betriebsfall auch dann geschlossen werden, wenn festgestellt wird, dass ein Strom über die Bypassdioden 4 fließt. So kann die entstehende thermische Belastung der Bypassdioden 4 reduziert werden, wodurch ein Aufwand zur Entwärmung der Modulelektronik entfallen oder reduziert werden kann.

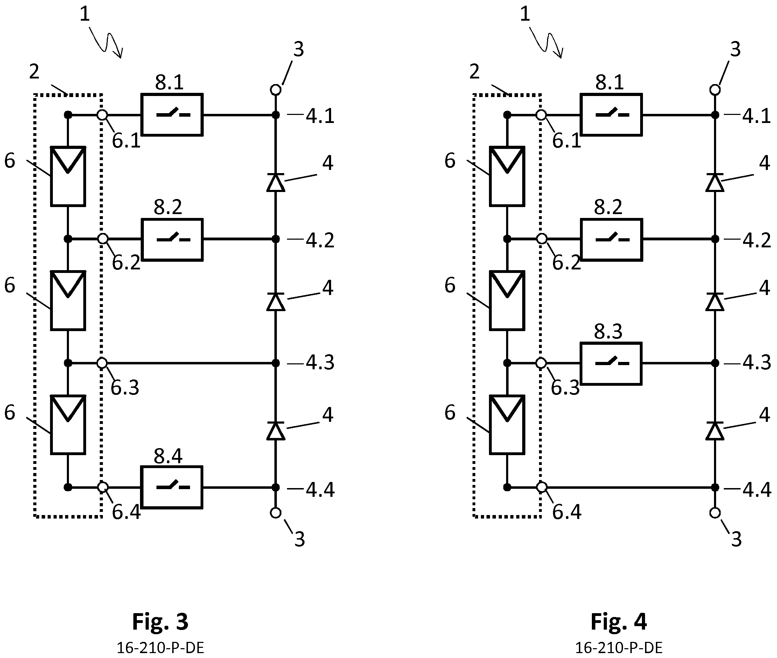

In der Fig. 3 ist eine Anordnung von drei Halbleiterschaltern 8.1, 8.2 und 8.4 gezeigt, die alle in den jeweiligen Verbindungspfaden zwischen den Teilmodulanschlüssen 6.1 bis 6.4 und den Bypassanschlüssen 4.1 bis 4.4 angeordnet sind. In dieser Ausführung kann am Halbleiterschalter 8.1, anders als bei den Halbleiterschaltern 8.2 und 8.4 die doppelte Leerlaufspannung eines Moduls abfallen, was bei der Dimensionierung der Halbleiterschalter 8.1 bis 8.4 zu berücksichtigen ist. Trotzdem kann eine Kosteneinsparung durch günstigere Halbleiterschalter erreicht werden.

Die in Fig. 4 gezeigte Anordnung von Halbleiterschaltern 8.1 bis 8.3 unterscheidet sich nur dadurch von der in Fig. 3 gezeigten Anordnung, dass nunmehr der zwischen dem Teilmodulanschluss 6.3 und dem Bypassanschluss 4.3 angeordnete Halbleiterschalter 8.3 den Halbleiterschalter 8.4 ersetzt. Hierdurch sollte der Halbleiterschalter 8.2 auf die doppelte Leerlaufspannung und der Halbleiterschalter 8.1 auf die dreifache Leerlaufspannung eines Solarteilmoduls 6 ausgelegt werden. Besonderer Vorteil dieser Anordnung ist, dass alle Halbleiterschalter 8.1 bis 8.3 auf einem Potential oberhalb des Potentials am Bypassanschluss 4.4 liegen. Hierdurch wird es besonders einfach, durch die Sicherungseinheit 5 die Steuerspannungen für die Halbleiterschalter zu erzeugen.

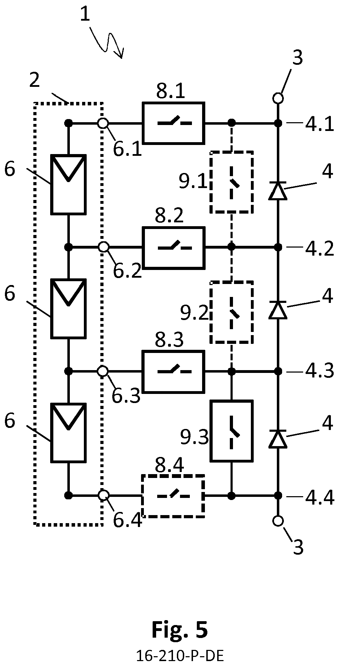

Ausgehend von der Anordnung der Halbleiterschalter aus Fig. 4 können in der Ausführungsform gemäß Fig. 5 ein, zwei oder drei Halbleiterschalter 9.1, 9.2 und 9.3 hinzugefügt werden, die jeweils einer Bypassdiode 4 parallelgeschaltet sind. Weiterhin kann der Halbleiterschalter 8.4 aus Fig. 3 erneut hinzugefügt werden. Hierdurch kann die maximale Spannungsbelastung der Halbleiterschalter 8.1 bis 8.4 reduziert und gleichzeitig die Betriebssicherheit des Solarmoduls 1 erhöht werden, wenn das Solarmodul 1 in einen spannungsfreien Zustand zu versetzen ist. Insbesondere ist es denkbar, dass die Sicherungseinheit 5 zunächst diejenigen der Halbleiterschalter 8.1 bis 8.4 öffnet und diejenigen der Halbleiterschalter 9.1 bis 9.3 schließt, dass sich eine der durch die vorstehend mit weniger Halbleiterschaltern beschriebenen Ausführungsformen realisierbaren Schaltkonfigurationen zum Erreichen eines spannungsfreien Zustandes ergibt. Anschließend überprüft die Sicherungseinheit 5, ob ein spannungsfreier Zustand erreicht wurde oder beispielsweise aufgrund eines defekten Halbleiterschalters noch Spannung an den Solarmodulanschlüssen 3 anliegt. Sollte Letzteres der Fall sein, wechselt die Sicherungseinheit 5 in eine andere der vorstehend beschriebenen Schaltkonfigurationen. Dies kann solange fortgesetzt werden, bis eine Schaltkonfiguration gefunden ist, die einen spannungsfreien Zustand ermöglicht. Die Sicherungseinheit 5 kann die nicht funktionalen Schaltkonfigurationen speichern, gegebenenfalls an eine übergeordnete Einheit weitermelden, und diese in Zukunft nicht weiterverwenden.

Die Sicherungseinheit 5 kann in einem Beispiel ausgehend von einem normalen Betriebszustand des Solarmoduls 1, in dem die Halbleiterschalter 8.1 bis 8.4 geschlossen und die Halbleiterschalter 9.1 bis 9.3 geöffnet sind, bei gefordertem Wechsel in einen spannungsfreien Zustand zunächst die Halbleiterschalter 8.1 und 8.4 öffnen und den Halbleiterschalter 9.2 schließen und gelangt so zu der in Fig.1 offenbarten Schaltkonfiguration. Sollte ein spanungsfreier Zustand hierdurch nicht erreicht werden, schließt die Sicherungseinheit den Schalter 9.3 und gelangt so zur Schaltkonfiguration gemäß Fig. 2. So können sukzessive weitere Schaltkombinationen zum Erreichen eines spannungsfreien Zustandes angenommen werden, bis hin zu einer Konfiguration, in der alle Halbleiterschalter 9.1 bis 9.4 geschlossen und alle Halbleiterschalter 8.1 bis 8.4 geöffnet sind. So kann das Solarmodul 1 auch dann in einen spannungsfreien Zustand gebracht werden, wenn einer oder mehrere Komponenten der Modulelektronik nicht ordnungsgemäß funktionieren.

### Bezugszeichenliste

- 1: Solarmodul
- 2: Reihenschaltung
- 3: Anschluss
- 4: Bypassdiode
- 4.1-4.4: Bypassanschluss
- 5: Sicherungseinheit
- 6: Solarteilmodul
- 7: Modulelektronik
- 6.1-6.4: Teilmodulanschluss
- 8,8.1-8.4: Halbleiterschalter
- 9, 9', 9.1-9.3: Halbleiterschalter
- 11: Schaltsignal
- 12: Versorgungsleitung

## Patentansprüche

1. Solarmodul (1) mit einer zwischen Anschlüssen (3) angeordneten Reihenschaltung von Bypassdioden (4) mit Bypassanschlüssen (4.1 bis 4.4) jeweils an beiden Enden und allen Verbindungspunkten der Bypassdiodenreihenschaltung und einer Reihenschaltung (2) von Solarteilmodulen (6) mit Teilmodulanschlüssen (6.1 bis 6.4) jeweils an beiden Enden und allen Verbindungspunkten der Solarmodulreihenschaltung, wobei jede Bypassdiode (4) genau einem Solarteilmodul (6) zugeordnet ist, und einer Mehrzahl von Halbleiterschaltern (8.1 bis 8.4, 9.1 bis 9.4) zur Spannungsfreischaltung der Solarmodulanschlüsse (6.1 bis 6.4) bei Empfang eines Freischaltsignals durch eine Sicherungseinheit (5)
**dadurch gekennzeichnet, dass**
jeder der Mehrzahl von Halbleiterschaltern (8.1 bis 8.4, 9.1 bis 9.4) dazu eingerichtet ist, ein ihnen zugeordnetes Solarteilmodul spannungslos oder stromlos zu schalten, sowie mindestens ein Bypassanschluss (4.1 bis 4.4) direkt mit dem zugeordneten Teilmodulanschluss (6.1 bis 6.4) und mindestens ein Bypassanschluss (4.1 bis 4.4) über einen der Halbleiterschalter (8.1 bis 8.4) mit dem zugeordneten Teilmodulanschluss (6.1 bis 6.4) verbunden sind.

2. Solarmodul (1) nach Anspruch 1, umfassend genau drei Solarteilmodule (6).

3. Solarmodul (1) nach Anspruch 1 oder 2, wobei die Anzahl der Halbleiterschalter (8.1 bis 8.4, 9.1 bis 9.4) der Anzahl der Solarteilmodule (6) entspricht.

4. Solarmodul (1) nach einem der vorangehenden Ansprüche, wobei mindestens eine Bypassdiode (4) durch einen der Halbleiterschalter (9.1 bis 9.3) überbrückt ist.

5. Solarmodul (1) nach einem der vorangehenden Ansprüche, wobei der den mindestens einen Bypassanschluss (4.1 bis 4.4) mit dem zugeordneten Teilmodulanschluss (6.1 bis 6.4) verbindende Halbleiterschalter (8.1, 8.4) direkt mit einem der Solarmodulanschlüsse (3) verbunden ist.

6. Solarmodul (1) nach Anspruch 4, wobei jeder Solarmodulanschluss (3) jeweils mit einem einen Bypassanschluss (4.1 bis 4.4) mit dem zugeordneten Teilmodulanschluss (6.1 bis 6.4) verbindenden Halbleiterschalter (8.1, 8.4) direkt verbunden ist.

7. Solarmodul (1) nach einem der vorangehenden Ansprüche, wobei die Sicherungseinheit (5) zur Energieversorgung aus einer Spannung der Solarteilmodule (6) eingerichtet ist.

8. Solarmodul (1) nach einem der vorangehenden Ansprüche, wobei beide Bypassanschlüsse (4.1 bis 4.4) der mindestens einen durch einen der Halbleiterschalter (9.1 bis 9.3) überbrückten Bypassdiode (4) jeweils direkt mit den zugeordneten Teilmodulanschlüssen (6.1 bis 6.4) verbunden sind.

9. Solarmodul (1) nach Anspruch 7, wobei dem die Bypassdiode (4) überbrückenden Halbleiterschalter (9.1 bis 9.3) ein weiterer, redundanter Halbleiterschalter (9.1' bis 9,3') parallelgeschaltet ist.

10. Energieerzeugungsanlage umfassend eine Reihenschaltung (2) von Solarmodulen (1) nach einem der vorangehenden Ansprüche.

## Claims

1. A solar module (1) comprising a series circuit of bypass diodes (4) arranged between connections (3), with bypass connections (4.1 to 4.4) at both ends and at all connecting points of the series circuit of bypass diodes and comprising a series circuit (2) of solar partial modules (6) with partial module terminals (6.1 to 6.4) at both ends and at all connecting points of the series circuit of solar partial modules, wherein each bypass diode (4) is associated with precisely one solar partial module (6), and comprising a plurality of semiconductor switches (8.1 to 8.4, 9.1 to 9.4) for removing voltage from the solar module connections (6.1 to 6.4) when a disconnection signal is received by a safety unit (5),
**characterized in that**
each of the plurality of semiconductor switches (8.1 to 8.4, 9.1 to 9.4) is configured to switch an associated solar partial module into a voltage-free or current-free state, and that at least one bypass connection (4.1 to 4.4) is directly connected to the associated partial module terminal (6.1 to 6.4) and that at least one bypass connection (4.1 to 4.4) is connected to the associated partial module terminal (6.1 to 6.4) by means of one of the semiconductor switches (8.1 to 8.4).

2. The solar module (1) as claimed in claim 1, comprising precisely three solar partial modules (6).

3. The solar module (1) as claimed in claim 1 or 2, wherein the number of semiconductor switches (8.1 to 8.4, 9.1 to 9.4) corresponds to the number of solar partial modules (6).

4. The solar module (1) as claimed in one of the preceding claims, wherein at least one bypass diode (4) is bridged by one of the semiconductor switches (9.1 to 9.3).

5. The solar module (1) as claimed in one of the preceding claims, wherein the semiconductor switch (8.1, 8.4) connecting the at least one bypass connection (4.1 to 4.4) to the associated partial module terminal (6.1 to 6.4) is directly connected to one of the solar module connections (3).

6. The solar module (1) as claimed in claim 4, wherein each solar module connection (3) is directly connected in each case to a semiconductor switch (8.1, 8.4) connecting a bypass connection (4.1 to 4.4) to the associated partial module terminal (6.1 to 6.4).

7. The solar module (1) as claimed in one of the preceding claims, wherein the safety unit (5) is configured to supply energy from a voltage of the solar partial modules (6).

8. The solar module (1) as claimed in one of the preceding claims, wherein both bypass connections (4.1 to 4.4) of the at least one bypass diode (4) being bridged by one of the semiconductor switches (9.1 to 9.3) are each directly connected to the associated partial module terminals (6.1 to 6.4).

9. The solar module (1) as claimed in claim 7, wherein a further, redundant semiconductor switch (9.1' to 9.3') is connected in parallel with the semiconductor switch (9.1 to 9.3) bridging the bypass diode (4).

10. An energy-generating system comprising a series circuit (2) of solar modules (1) as claimed in one of the preceding claims.

## Revendications

1. Panneau photovoltaïque (1) avec un montage en série, disposé entre des bornes (3), de diodes de dérivation (4) avec des bornes de dérivation (4.1 à 4.4) à chaque fois aux deux extrémités et tous les points de connexion du montage en série des diodes de dérivation et un montage en série (2) de panneaux photovoltaïques partiels (6) avec des bornes de panneaux photovoltaïques partiels (6.1 à 6.4) à chaque fois aux deux extrémités et à tous les points de connexion du montage en série des panneaux photovoltaïques, chaque diode de dérivation (4) étant affectée à exactement un panneau photovoltaïque partiel (6), et plusieurs commutateurs à semi-conducteurs (8.1 à 8.4, 9.1 à 9.4) pour la coupure des bornes des panneaux photovoltaïques (6. 1 à 6.4) lors de la réception d'un signal de libération par une unité de fusibles (5), **caractérisé en ce que** chacun de la pluralité de commutateurs à semi-conducteurs (8.1 à 8.4, 9.1 à 9.4) est conçu pour éteindre ou mettre hors tension un panneau photovoltaïque partiel qui lui est affecté, et au moins une borne de dérivation (4. 1 à 4.4) est directement reliée à la borne de panneau photovoltaïque partiel associé (6.1 à 6.4) et au moins une borne de dérivation (4.1 à 4.4) est reliée à la borne de panneau photovoltaïque partiel associé (6.1 à 6.4) par l'intermédiaire d'un des commutateurs à semi-conducteurs (8.1 à 8.4).

2. Panneau photovoltaïque (1) selon la revendication 1, comprenant exactement trois panneaux photovoltaïques partiels (6).

3. Panneau photovoltaïque (1) selon la revendication 1 ou 2, dans lequel le nombre de commutateurs à semi-conducteurs (8.1 à 8.4, 9.1 à 9.4) correspond au nombre de panneaux photovoltaïques partiels (6).

4. Panneau photovoltaïque (1) selon l'une des revendications précédentes, dans lequel au moins une diode de dérivation (4) est contournée par l'un des commutateurs à semi-conducteurs (9.1 à 9.3).

5. Panneau photovoltaïque (1) selon l'une des revendications précédentes, dans lequel le commutateur à semi-conducteurs (8.1, 8.4) reliant la au moins une borne de dérivation (4.1 à 4.4) à la borne de panneau photovoltaïque partiel associé (6.1 à 6.4) est directement relié à l'une des bornes de panneau photovoltaïque (3).

6. Panneau photovoltaïque (1) selon la revendication 4, dans lequel chaque borne de panneau photovoltaïque (3) est directement reliée dans chaque cas à un commutateur à semi-conducteurs (8.1, 8.4) reliant une borne de dérivation (4.1 à 4.4) à la borne de panneau photovoltaïque partiel associé (6.1 à 6.4).

7. Panneau photovoltaïque (1) selon l'une des revendications précédentes, dans lequel l'unité de fusibles (5) est mise en place pour l'alimentation électrique à partir d'une tension des panneaux photovoltaïques partiels (6).

8. Panneau photovoltaïque (1) selon l'une des revendications précédentes, dans lequel les deux bornes de dérivation (4.1 à 4.4) de la au moins une diode de dérivation (4) pontée par l'un des commutateurs à semi-conducteurs (9.1 à 9.3) sont chacune directement reliées aux bornes de panneaux photovoltaïques partiels associés (6.1 à 6.4).

9. Panneau photovoltaïque (1) selon la revendication 7, dans lequel un autre commutateur à semi-conducteur redondant (9.1 à 9.3) est connecté en parallèle avec le commutateur à semi-conducteur (9.1 à 9.3) qui ponte la diode de dérivation (4).

10. Système de production énergétique comprenant un montage en série (2) de panneaux photovoltaïques (1) selon l'une des revendications précédentes.
